Europäisches Patentamt

European Patent Office

Office européen des brevets

(19)

(11) Publication number: **0 149 685 B1**

## EUROPEAN PATENT SPECIFICATION
published in accordance with Art. 158(3) EPC

(12)

(45) Date of publication of patent specification: **08.05.91**

(51) Int. Cl.5: **H01L 21/66, G01N 21/88**

(21) Application number: **84902938.4**

(22) Date of filing: **25.07.84**

(86) International application number:
**PCT/JP84/00376**

(87) International publication number:
**WO 85/00696 (14.02.85 85/04)**

(54) **METHOD FOR AUTOMATICALLY COUNTING ETCHED PITS.**

(30) Priority: **25.07.83 JP 135308/83**

(43) Date of publication of application:
**31.07.85 Bulletin 85/31**

(45) Publication of the grant of the patent:
**08.05.91 Bulletin 91/19**

(84) Designated Contracting States:
**DE FR GB**

(56) References cited:
**DE-A- 1 498 814**      **JP-A- 5 757 246**
**JP-B- 4 627 639**      **US-A- 3 214 574**
**US-A- 3 824 393**      **US-A- 4 045 655**

(73) Proprietor: **SUMITOMO ELECTRIC INDUSTRIES LIMITED**
**No. 15, Kitahama 5-chome, Higashi-ku Osaka-shi, Osaka 541(JP)**

(72) Inventor: **TAGUCHI,Tetsuya Osaka Works of Sumitomo Electric**
**Industries, Ltd. 1-3, Shimaya 1-chome Konohana-ku,,Osaka-shi Osaka 554(JP)**
Inventor: **KAWASAKI,Akihisa Osaka Works of Sumitomo Electric**
**Industries, Ltd. 1-3, Shimaya 1-chome Konohana-kuu,Osaka-shi Osaka 554(JP)**

(74) Representative: **Rackham, Stephen Neil et al GILL JENNINGS & EVERY 53-64 Chancery Lane**
**London WC2A 1HN(GB)**

## Description

Technical Field

The present invention relates to a method of automatically counting the number of etch pits on the surface of a semiconductor crystal substrate (wafer).

Background Art

A semiconductor single crystal is generally produced by the pulling method, the Bridgeman method, and so on. An ingot of the single crystal is sliced to form semiconductor wafers. The surface of the wafer is lapped and polished to form a semiconductor device thereon by means of the epitaxial growth method, the photo etching method, etc.

Since the wafer is a slice of the single crystal, it leaves lattice defects in the form in which they existed in the original crystal. "Etch pits" means recesses corresponding to the lattice defects which appear on the surface of the semiconductor wafer when it is etched by etchant. In a three-dimensional crystal, many lattice defects continuously exist therein in the form of lines. When the crystal is sliced as a wafer, the lines of the lattice defects are interrupted and, therefore, if the surface of the wafer is etched, the interrupted portions of the lattice defects remain as recesses. The etch pits density (EPD) is defined by the number of etch pits per unit area. The value of the EPD represents the amount of lattice defects in the wafer and has many influences on the characteristic of the semiconductor device formed on the wafer. Thus, the count of the number of etch pits is one of the significant parameters to be measured in connection with the production of a semiconductor device.

The etch pits density varies in the seed end, the middle portion and the tail end (in the direction parallel to a growth axis) of a single crystal which has been pulled and varies, even in a single wafer, at the vicinity of the central portion, the intermediate portion and the peripheral portion of the wafer. This means that, for each wafer, the etch pits density must be measured at a large number of points of measurement.

Each of the etch pits is a recess appearing on the wafer surface etched by the use of a proper etchant and has a limited area. The area of a single recess does not always have a fixed value. There are both relatively large and small etch pits. It is significant enough to count the number of etch pits and measuring the area of the respective etch pits is therefore out of the question.

However, the etch pits comprise not only isolated ones, but also overlapping ones. The image of overlapping etch pits does not have specified contour and though it can be distinguished from a single isolated etch pit, it is difficult to know how many etch pits are involved in a single grouping thereof.

The measurement of the etch pits density of the semiconductor wafer can be effected by observing the wafer surface enlarged by a microscope and then counting the number of etch pits therein. The counting of the number of etch pits within a fixed area is merely simple work and does not require complex operations.

The operator attending to such measurement, however, must continue viewing through the microscope and count the etch pits for many hours, because of the large number of measured points and wafers. Although operation efficiency can be increased in proportion to the operator's skill, he will inevitably become exhausted. Also, counting of the etch pits by means of the human eye will increase the cost of the measurement, because of the limitation on operating speed.

Under such circumstances, various attempts have been made to automize the counting of the etch pits.

JP-A-59-212741 discloses a system in which the surface image of the crystal wafer is enlarged by a microscope and detected by an optical sensor. The output of the sensor is converted to digital data by a digital voltmeter. The digital data output by the voltmeter is analysed to enable determination of the density of the etch pits over the area of the wafer. The teaching of this document corresponds to the statement of Claim 1.

It is known, outside the specific field of the present invention, to automate counting systems. US-A-4045655, for example, discloses a device for counting cells under a microscope. In this device, the magnified image of the cells is converted to an electrical signal by a television camera. Logic circuits are used to process the resulting signal in order to recognise and count the number of cells. The logic circuits are also arranged to determine the areas of different cells. Analogous techniques may be applied to provide an automatic etch pits counting system.

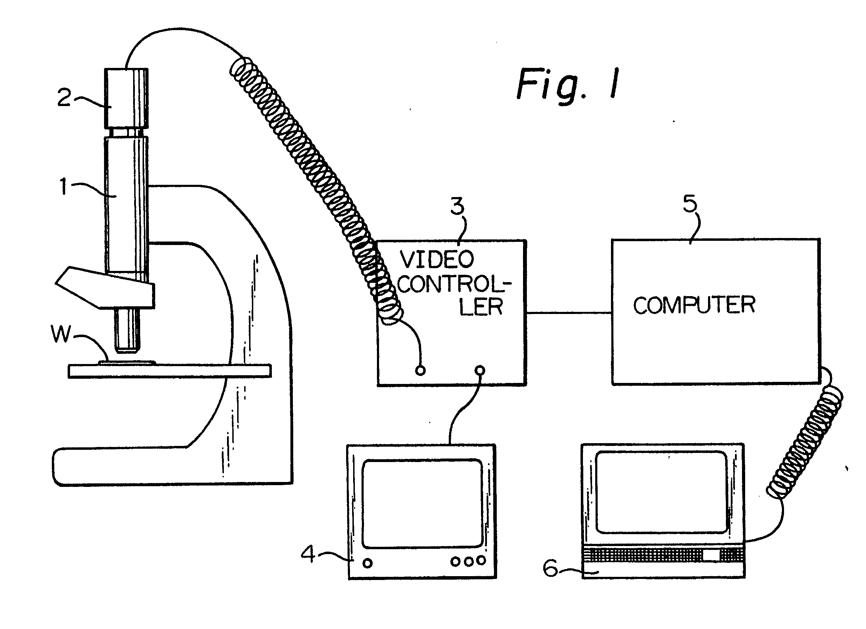

Figure 1 shows a schematic diagram of an automatic etch pits counting system.

Provided on a microscope 1 is an ITV camera 2 which outputs video signals representing an enlarged image of the surface of wafer W, the signals being processed by a computer 5. The reference numeral 3 denotes a video controller, 4 denotes a monitor television, and 6 denotes a console for applying operating instructions to the computer, which has a display for displaying information such as input instructions and counting results.

The enlarged images of the surface of the wafer W will present various states. Depending on such states, the etch pits density may be low or high. If the etch pits density is high, a plurality of etch pits have tendency to overlap one another.

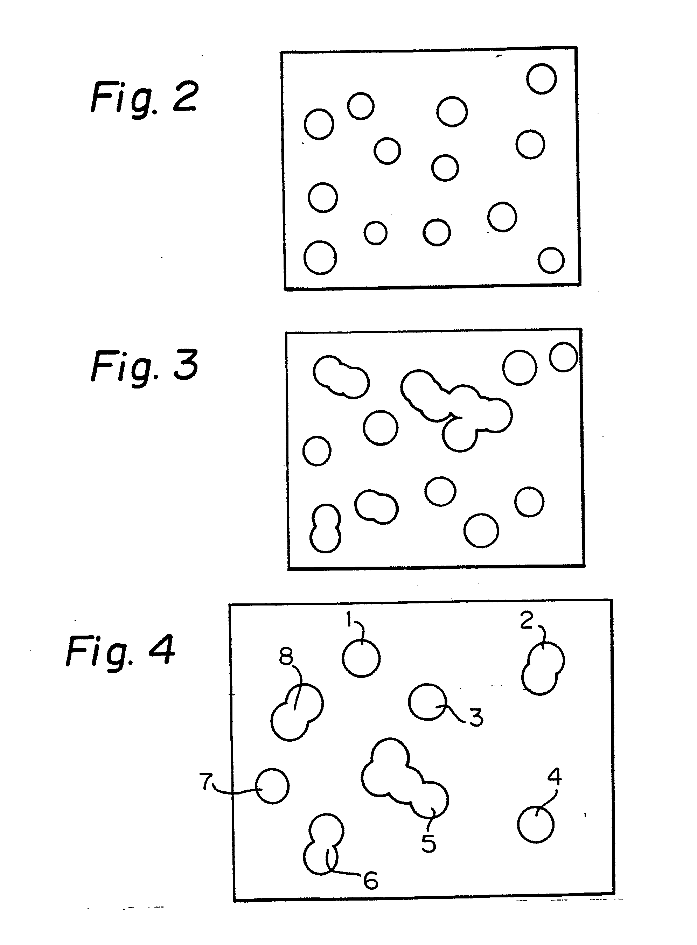

Figures 2 and 3 show respective examples of the enlarge wafer images. Figure 2 shows one example in which only individually isolated etch pits exist and a single etch pit in the image is shown as a circle.

In the case of the image including only the individually isolated etch pits, the number of etch pits can be automatically counted on the basis of the video signals outputted from the ITV camera 2 and the counted value directly equals the number of etch pits.

In the case of the overlapping etch pits, it is difficult to count them automatically. Figure 3 is an enlarged diagram showing a wafer having overlapping etch pits. If a plurality of etch pits overlap each other, there is no simple form. Furthermore, the number of overlapping etch pits is indefinite. For example, if two etch pits overlap each other, they appear in the form of dumbbells, and if a number of etch pits overlap each other then a form like a shapeless cloud is presented.

If the operator counts the etch pits with his own eyes, he can perceive and count the number of overlapping etch pits, while viewing the form thereof.

On the other hand, in the case of an automatized system, it is not easy to identify from a grouping of etch pits the number of etch pits included therein. However, calculating the area of an individual etch-pit image can be easily carried out.

The average area A of an isolated etch pit is predetermined, the area S of the image of a grouping of etch pits is measured and then the area S is arithmetically divided by the average unit area A to estimate the number of etch pits in the image. Thus, for each of all the etch-pit images i within the scope of a visual field, the number of etch pits $n_i$ is estimated to obtain the total number of etch pits in that field.

That is, assuming that the etch-pit images in the visual field are 1,2,..., m and the areas thereof are $S_1, S_2,...,S_m$, respectively, the number of etch pits $n_i$ in the i-th etch-pits image is given by

$$n_i = [\frac{S_i}{A}] \qquad\qquad (1)$$

and the total number of etch pits N is given by

$$N = \sum_{i=1}^{m} n_i \qquad\qquad (2)$$

or

$$N = \sum_{i=1}^{m} [\frac{S_i}{A}] \qquad\qquad (3)$$

where the average unit area A is common to all points on a wafer. In addition, the area A is assumed to present a fixed value for every wafer. The representation [x] means that fractions of .5 and over are counted as a unit and that the rest are disregarded in connection with the value of x.

At this stage, a problem appears. If the total number of etch pits can be estimated by means of the formula (3), it would be very convenient and simple. It should be noted, however, that the unit area of an etch pit varies for every wafer and, even in the same wafer, at every measured point.

Therefore, it is impossible in such a manner to calculate the precise density of etch pits, because of a relatively large counting error.

## Disclosure of the Invention

It is an object of the present invention to provide an automatic etch pits counting method of measuring precisely the etch pits density on the wafer.

The automatic etch pits counting method of the above system has utilized only one average unit area A, in spite of the variation of the measured points thereon.

In contrast, according to the present invention, the average unit area A is calculated and decided for every wafer, or at every relatively fractionalized measured point thereon.

According to the present invention, there is provided a method of counting the number of etch pits in a semiconductor single crystal wafer comprising enlarging the surface image of the crystal wafer with a microscope, converting the image to corresponding digital data, and analysing the digital data to determine the density of etch pits over the area of the wafer, characterised in that the enlarged image is converted to video signals by a TV camera and the step of analysing the digital data comprises processing the image of the etch pits from the TV camera in a computer to obtain the area of individual etch pits, calculating the average unit area of the isolated etch pits for every wafer or at every measured point thereof, dividing the area of a group of overlapping etch pits by the average unit area, rounding off the resulting quotient to be an integer thereby obtaining the number of etch pits in the area, and automatically determining the total number of etch pits by totalling the number of isolated etch pits and the number of overlapping etch pits.

According to the present invention, the etch pits on a semiconductor wafer are automatically counted and, therefore, the operation for measuring is very fast and precise. Also, the operator is little tired and the number of operators can be reduced.

If the operator counts the etch pits by his own eyes through a microscope, he would count them at 10 points per wafer at least. According to the present invention, it is easy to calculate the EPD at 50-100 points of measurement per wafer. Because of the increase of operating efficiency, the number of measured points can be increased and the quality of the semiconductor wafer can be strictly monitored.

According to the present invention, since the average unit area $A_p$ of the isolated etch pit is obtained for every wafer or at every measured point thereon, precise results of counting, or counting with little error, can be achieved, in comparison with the prior art which uses the average unit area A of a fixed value.

Brief Description of the Drawings

Fig. 1 is a constitutional diagram showing one embodiment of an automatic etch pits counting system;
Fig. 2 is an enlarged plane view of a wafer surface on which only isolated etch pits exist;
Fig. 3 is an enlarged plane view of a wafer surface in which overlapping etch pits are included; and
Fig. 4 is a diagram showing an etch pits arrangement as an example for the purpose of explaining the steps of the counting system of the present invention.

Modes for Carrying out the Invention

According to the present invention, the average unit area A of an etch pit varies for every wafer or at every measured point thereon and, therefore, such area is defined by suffixing "p", that is, $A_p$. The suffix "p" is an index given for every wafer or every measured point.

First of all, a method of counting the number of etch pits by determined the average unit area $A_p$ for every measured point on the wafer will be explained.

In the same way as with a conventional system, the wafer W is placed on the sample base of the microscope 1. The enlarged image of the wafer is image-processed and converted to electrical signals by the ITV camera 2. While viewing monitor TV 4, the counting operation is automatically perfomed by the computer 5.

The following method can be effected by the computer 5 and the instructions from the console 6 thereto and the operator, therefore, does not need to view the image with his own eyes nor to perceive it using his brain.

The steps of the etch pits counting method of this invention are as follows:

Step (1): Picking up the images [i] of etch pits from the image of a wafer surface and obtaining the area $\{S_i\}$ thereof;

Step (2): Discriminating between the images of isolated or non-overlapping etch pits and the images of overlapping etch pits, on the basis of the shapes of the former (or in consideration of the dimension thereof);

Step (3): Obtaining the average unit area $A_p$ of the images of isolated etch pits, the images being given by the step (2); .

Step (4): Dividing the area $S_k$ of the image of overlapping etch pits k by the average unit area $A_p$ to calculate the number of etch pits included in the area $S_k$; and

Step (5): Totalling the number of isolated etch pits and the number of etch pits $n_k$ included in the image of overlapping etch pits to obtain the total number of etch pits N, so that the etch pits density EPD may be obtained by dividing the value of N by the area involved in the visual field of the microscope.

In the case of varying the area $A_p$ for every measured point, all of the steps (1) to (5) are performed therefor. In the case of using a fixed area $A_p$ for every wafer, the steps (1) to (5) are performed only once for a first wafer and then those steps other than step (3) are performed for every subsequent measured point.

Detailed explanation will be given below.

Step (1) is to give numbers 1, 2 ..., m to the respective etch pits and obtain the corresponding areas $S_1$, $S_2$, ..., $S_m$.

In order to obtain the area, a two-dimensional image, which comprises the etch pits and the background thereof, is processed as a binary image in the form of black and white which, for example, corresponds to the etch pits and the background, respectively. Then, the image is divided into a grouping of microscopic cells in the form of a matrix configuration. The area of the cell is a fraction of the area of the etch pit and is extremely small. The area $S_i$ of the etch pit i is estimated by counting the number of cells which fill that each pit.

The method of obtaining such area is publicly known.

In step (2), discrimination between isolated etch pits and the groupings of etch pits can be accomplished by the following:

Superimposing a regular square having a fixed size on an etch pit and investigating the shape and size of parts which protrude from the four sides of the square, and then, if the parts protrude equivalently therefrom, that etch pit is considered to be an isolated etch pit and if not, to be a grouping of etch pits; or Superimposing a circle having a fixed size on an etch pit and then, if the etch pit is included therein, it is considered to be an isolated etch pit; or

Predetermining several standard patterns for isolated etch pits and superimposing these patterns on an etch pit and then, if there is a coincidence between the etch pit and one of the patterns, it is considered to be an isolated etch pit.

Thus, depending upon the shape and size, discrimination between isolated etch pits and groupings of etch pits can be accomplished. This discrimination has been effected by conventional methods.

After discrimination between the isolated etch pits and the groupings of etch pits, an average value of the area of an isolated etch pit is obtained and this value is considered as an average unit area $A_p$ at that measured point. Assuming that the number of isolated etch pits is u,

$$A_p = \frac{1}{u} \sum_{(i)} S_i \qquad (4)$$

wherein (i) means the sum in relation to the isolated etch pit. This comprises step (3).

Step (4) is to divide the area $S_k$ of the image of the overlapping etch pits by the average unit area $A_p$ and to obtain the number of etch pits $n_k$ included in the area $S_k$, or

$$n_k = [\frac{S_k}{A_p}] \qquad (5)$$

where the representation [...] means that, in connection with values in the bracket, fractions of .5 and over are counted as a unit and the rest are disregarded.

Step (5) is to obtain the total number of etch pits N, or

$$N = \sum_{(i)} 1 + \sum_{(k)} n_k \qquad (6)$$

where the representation

$$\sum_{(i)}$$

of a first term means the sum on the isolated etch pit and

$$\sum_{(k)}$$

means the sum on the grouping of etch pits.

Assuming that the number of isolated etch pits is u,

$$N = u + \sum_{(k)} n_k \qquad (7)$$

Fig. 4 is a sample of a microscopic image at a certain measured point on the wafer surface. Although the number of etch pits is relatively large in fact, for the sake of simplicity, a small number of etch pits are shown.

First, numbers are given to the respective etch pits, e.g., Nos. 1 through 8 as shown in this sample. Next, the area $S_i$ of each of the etch pits is measured.

For the convenience of explanation, tables may be utilized. In these tables, "Etch Pit No.", "Area" and "Number of Etch Pits" are represented in horizontal columns, while the data on each of the etch pits are put in order in vertical columns. In an actual measurement, of course, such tables are not used.

**TABLE I : Data after the measurement of the areas of the numbered etch pits [Step (1)]**

| No. | Area | Number of Etch Pits |
|-----|------|---------------------|
| 1 | 6 | |
| 2 | 8 | |
| 3 | 4 | |
| 4 | 4 | |
| 5 | 19 | |
| 6 | 9 | |
| 7 | 5 | |
| 8 | 10 | |

Table I represents the data after step (1). The area corresponding to each of the etch pits is put in the associated column, as a multiple number of an area of any unit. The areas of Etch Pit Nos. 1, 2, 3, ... are given as 6, 8, 4, ..., respectively. Thus step (1) is completed.

In step (2), isolated etch pits are distinguished from the groupings of etch pits. It is assumed that, by means of the steps as described above, each of Etch Pit Nos. 1, 3, 4, 7 has been perceived as an isolated etch pit. In the case of an isolated etch pit, the numeral "1" is put in the corresponding column of "Number of Etch Pits" of the table. In the case of a grouping of etch pit, the corresponding column of "Number of Etch Pits" remains vacant. This is shown by Table II.

TABLE II : Numeral "1" in the column of "Number of
Etch Pits" corresponding to an isolated
etch pit [Step (2)]

| No. | Area | Number of Etch Pits |
|-----|------|---------------------|
| 1 | 6 | 1 |
| 2 | 8 | |
| 3 | 4 | 1 |
| 4 | 4 | 1 |
| 5 | 19 | |
| 6 | 9 | |
| 7 | 5 | 1 |
| 8 | 10 | |

Step (3) is to obtain the average unit area $A_p$ of each isolated etch pit. Etch Pit Nos. 1, 3, 4 and 7 are the isolated etch pits, respectively, and the areas corresponding thereto are 6, 4, 4, and 5, and therefore

$$A_p \frac{1}{4}(6 + 4 + 4 + 5) = 4.7$$

The area $S_k$ of the grouping of etch pits k is divided by $A_p$ and then the quotient is rounded off to be an integer which is considered as the number of etch pits $n_k$. For example, the respective areas of Etch Pit Nos. 2, 6 and 8 are 8, 9 and 10, and the value obtained by dividing each of such areas by $A_p$ ($= 4.7$) and rounding the quotient off is 2. Also, the area of Etch Pit No. 5 is 19, and the value obtained by dividing it by $A_p$ and rounding off is 4. Thus, the value of $n_k$ is put in the column of "Number of Etch Pits" corresponding to the grouping of etch pits. This is shown in Table III.

7

TABLE III : $n_k$ in the column of "Number of
Etch Pits" corresponding to the
grouping of etch pits

| No. | Area | Number of Etch Pits |
|-----|------|---------------------|
| 1 | 6 | 1 |
| 2 | 8 | 2 |
| 3 | 4 | 1 |
| 4 | 4 | 1 |
| 5 | 19 | 4 |
| 6 | 9 | 2 |
| 7 | 5 | 1 |
| 8 | 10 | 2 |

In this manner, regarding the number of etch pits, the values for Etch Pit Nos. 1 through 8 are perceived as 1, 2, 1, 1, 4, 2, 1 and 2.

In step (5), by totalling these values, the total number of etch pits $N = 14$ can be obtained.

Finally, the etch pits density (EPD) can be obtained by dividing the total number by the area of the wafer surface within the scope of the visual field.

Industrial Applicability

The present invention can be used to measure the etch pits density on the wafer surface of a semiconductor. The semiconductor wafers can be formed by slicing the ingots of single crystal such as GaAs InP, Si and Ge.

Generally, the present invention may be applied to a general system for measuring the number of particles in a continuous member.

Claims

1. A method of counting the number of etch pits in a semiconductor single crystal wafer (W) comprising enlarging the surface image of the crystal wafer with a microscope (1), converting the image to corresponding digital data, and analysing the digital data to determine the density of etch pits over the area of the wafer, characterised in that the enlarged image is converted to video signals by a TV camera (2) and the step of analysing the digital data comprises processing the image of the etch pits from the TV camera (2) in a computer (5) to obtain the area of individual etch pits, calculating the average unit area $A_p$ of the isolated etch pits for every wafer or at every measured point thereof, dividing the area $S_k$ of a group of overlapping etch pits k by the average unit area $A_p$, rounding off the resulting quotient to be an integer thereby obtaining the number of etch pits $n_k$ in the area $S_k$, and automatically determining the total number N of etch pits by totalling the number of isolated etch pits u and the number of overlapping etch pits $n_k$.

Revendications

1. Procédé de comptage du nombre de trous gravés dans une pastille d'un monocristal semiconducteur (W) consistant à agrandir l'image de surface de la pastille de cristal au moyen d'un microscope (1), à convertir l'image en une donnée numérique correspondante et à analyser la donnée numérique pour déterminer la densité des trous gravés sur la surface de la pastille, caractérisé en ce que l'image agrandie est convertie en signaux vidéo par une caméra TV (2) et l'étape d'analyser la donnée numérique consiste à traiter l'image des trous gravés de la caméra TV (2) dans un ordinateur (5) pour obtenir la surface des trous gravés individuels, à calculer la surface unitaire moyenne $A_p$ des trous gravés isolés pour chaque pastille ou à chaque point mesuré de celle-ci, à diviser la surface $S_k$ d'un groupe de trous gravés se chevauchant k par la surface unitaire moyenne $A_p$, à arrondir le quotient résultant pour que ce soit un nombre entier et ainsi obtenir le nombre de trous gravés $n_k$ dans la surface $S_k$, et à déterminer automatiquement le nombre total N de trous gravés en totalisant le nombre de trous gravés isolés u et le nombre de trous gravés se chevauchant $n_k$.

**Ansprüche**

1. Verfahren zum selbsttätigen Zählen von Ätzgrübchen in einem Einkristall-Halbleiterwafer, bei dem das Oberflächenbild des Kristallwafers mit einem Mikroskop (1) vergrößert wird, das Bild in entsprechende digitale Werte umgewandelt wird und diese zur Bestimmung der Dichte der Ätzgrübchen auf der Waferfläche ausgewertet werden,
**dadurch gekennzeichnet,**
daß das vergrößerte Bild von einer Fernsehkamera (2) in Videosignale umgewandelt wird und die Auswertung der digitalen Daten die Verarbeitung des von der Fernsehkamera (2) erhaltenen Bildes der Ätzgrübchen in einem Computer zum Erfassen der Fläche der einzelnen Ätzgrübchen, das Errechnen der durchschnittlichen Flächeneinheit $A_p$ der einzelnen Ätzgrübchen für jeden Wafer oder für jeden Meßpunkt eines Wafers, das Dividieren der Fläche $S_k$ einer Gruppe von einander überschneidenden Ätzgrübchen k durch die durchschnittliche Flächeneinheit $A_p$, das Abrunden des resultierenden Quotienten zu einer ganzen Zahl, womit die Anzahl der Ätzgrübchen $n_k$ auf der Fläche $S_k$ erhalten wird, und das automatische Bestimmen der Gesamtzahl N der Ätzgrübchen durch Zusammenzählen der Anzahl der einzelnen Ätzgrübchen u und der Anzahl der einander überschneidenden Ätzgrübchen $N_k$ umfaßt.

Fig. 1

Fig. 2

Fig. 3

Fig. 4